Europäisches Patentamt

European Patent Office

Office européen des brevets

(19)

(11) Veröffentlichungsnummer: **0 104 314**
**A2**

(12) **EUROPÄISCHE PATENTANMELDUNG**

(21) Anmeldenummer: **83104660.2**

(22) Anmeldetag: **11.05.83**

(51) Int. Cl.$^3$: **H 03 H 9/64**

(30) Priorität: **07.09.82 CH 5310/82**

(43) Veröffentlichungstag der Anmeldung:
**04.04.84 Patentblatt 84/14**

(84) Benannte Vertragsstaaten:
**CH DE FR LI**

(71) Anmelder: **SIEMENS-ALBIS AKTIENGESELLSCHAFT**
**EGA1/Verträge und Patente Postfach**
**CH-8047 Zürich(CH)**

(72) Erfinder: **Nyffeler, Felix, Dr.**
**a. Obfelderstrasse 18**
**CH-8910 Affoltern(CH)**

(54) SAW-Filter.

(57) Das SAW-Filter weist eine aperiodische Mäanderstruktur der Erdleitung auf. Dadurch kann bei der Dimensionierung der Wandlerstruktur ihre Eigenkapazität und ihr Eigenwiderstand zur Bildung der RC-Glieder eines Phasenschiebers in einer besonders einfachen Weise mit berücksichtigt werden.

FIG.2

EP 0 104 314 A2

SIEMENS-ALBIS AG    – 1 –    Unser Zeichen

Zürich    82P9811

SAW-Filter

Die vorliegende Erfindung betrifft ein SAW-Filter nach dem Oberbegriff des Patentanspruches 1.

SAW-Filter ( Surface Acoustic Waves ) sind bekanntlich elektrische Filter, die mit elastischen Druckwellen arbeiten, die sich entlang der Oberfläche piezoelektrischer Kristalle ausbreiten. Solche SAW-Filter, die beispielsweise aus dem Aufsatz "Mikrowellenakustik" in der "Technischen Rundschau" Nr.16, 18.4.1978, Seite 17ff bekannt sind, können allerdings mit Frequenzen arbeiten, die weit über dem rein akustischen Bereich liegen. Das Kernstück eines bekannten SAW-Filters besteht aus einem piezoelektrischen Substrat, auf dem ein Sendewandler und ein Empfangswandler angeordnet sind, die fingerförmig ineinandergreifende Elektroden aufweisen, wobei sowohl der Abstand zwischen zwei Elektroden als auch die Breite der Elektroden konstant ist.

Derartige SAW-Filter arbeiten in der Weise, dass wenn ein elektrisches Eingangssignal von einer Signalquelle an den Sendewandler angelegt wird, dort ein periodisches elektrisches Feld erzeugt und unter der Wirkung der piezoelektrischen Kopplung das Eingangssignal in eine elastische Oberflächenwelle umgesetzt wird, die entlang dem piezoelektrischen Substrat fortschreitet. Die elastische Oberflächenwelle erreicht sodann den Empfangswandler und wird von diesem in ein elektrisches Ausgangssignal umgesetzt, das einer externen Last zugeführt wird. Sende- und Empfangswandler bilden somit einen Uebertrager mit einer charakteristischen Uebertragungsfunktion. In der Praxis wird von SAW-Filtern eine möglichst ausgeprägte Filtercharakteristik gefordert.

Nun werden bei einfachen Wandlertypen die Oberflächenwellen in den zwei Richtungen abgestrahlt, wodurch Verluste auftreten. Auch ist die Anpassung einfacher Wandler an die Quellenimpedanz nicht möglich. Es werden daher Richtwandler verwendet, die als Dreiphasenwandler oder als Gruppenwandler arbeiten. Dreiphasenwandler sind mehrschichtig aufgebaut und deshalb sehr aufwendig in der Herstellung. Die Gruppenwandler hingegen sind planar aufgebaut und wesentlich einfacher herzustellen.

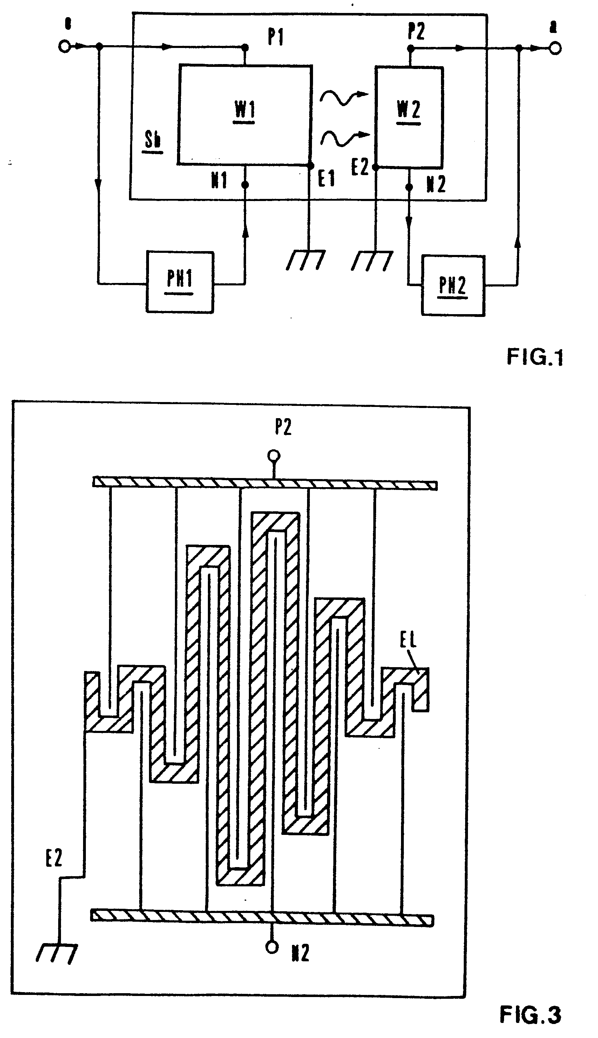

Bekannte Gruppenwandler weisen mehrere Elektrodengruppen auf, die je aus einer Anzahl 2n Elektroden bestehen, von denen n nacheinander liegende Elektroden eine halbe Gruppe einer Phasenlage und die n restlichen nacheinander liegenden Elektroden eine halbe Gruppe einer anderen Phasenlage bilden, wobei jeweils zwischen zwei Halbgruppen eine mäanderförmige Erdleitung hindurchgeführt ist. Zudem werden noch zusätzliche geerdete Elektrodenfinger zwischen den n Elektroden eingefädelt. Bei einem Filter mit mehreren Gruppen kann im Endeffekt die Anpassung an die Quellenimpedanz erst mit Hilfe von Phasenschiebern erreicht werden. Solche Filter erweisen sich jedoch als nachteilig in bezug auf die unerwünschten Nebenfrequenzmaxima. Um diesen Nachteil zu vermeiden, sind beispielsweise aus dem "Hewlett-Packard Journal", Dez. 1981, Seite 5, Wandler bekannt, bei denen die Länge der Fingerelek- troden unterschiedlich bemessen ist (Fig.3). Vgl. auch z.B.: Ultrasonics Symposium, 22.-24. Sept. 1975, IEEE Group on Sonics & Ultrasonics, S. 317-321 oder 6th European Microwave Conference 1976, Rom 14. bis 17. Sept. 1976 AEI, S. 267-271. Durch diese Massnahme können zwar die Nebenfrequenzmaxima unterdrückt werden, aber es müssen relativ aufwendige Phasenschieber vorgesehen werden.

Die der Erfindung zugrundeliegende Aufgabe besteht daher darin, ein SAW-Filter mit Richtwandlern zu schaffen, das eine ausgeprägte Resonanzfrequenz aufweist und eine leichte Anpassung an die Quellenimpedanz zulässt.

Dies wird erfindungsgemäss mit einem SAW-Filter erreicht, wie es im Anspruch 1 gekennzeichnet ist.

Vorteilhafte Ausgestaltungen der Erfindung sind in weiteren Ansprüchen angegeben.

Die Erfindung wird nachfolgend durch Ausführungsbeispiele anhand von Zeichnungen näher beschrieben. Es zeigt :

Fig.1 den prinzipiellen Aufbau eines SAW-Filters mit einem Sende- und einem Empfangswandler und mit zwei Phasenschiebern,

Fig.2 die schematische Darstellung eines erfindungsgemässen Richtwandlers,

Fig.3 die schematische Darstellung eines Richtwandlers mit unterschiedlich langen Elektrodenfingern nach dem Stand der Technik,

Fig.4 und 5 weitere Beispiele von Wandlerstrukturen nach der Erfindung,

Fig.6 einen Phasenschieber zu einem SAW-Filter gemäss Fig.1.

Das SAW–Filter nach Fig.1 weist ein piezoelektrisches Substrat Sb auf, auf welchem ein Sendewandler W1 und ein Empfangswandler W2 angebracht sind. Dabei wird ein Eingangssignal e einerseits dem einen Anschluss P1 und andererseits über einen 90°–Phasenschieber PH1 dem anderen Anschluss N1 des Sendewandlers W1 zugeführt. Entsprechend ist ein erster Anschluss N2 des Empfangswandlers W2 über einen weiteren 90°–Phasenschiebers PH2 mit seinem zweiten Anschluss P2 verbunden, dem das Ausgangssignal a entnommen wird. Beide Wandler W1 und W2 sind über weitere Anschlüsse E1 bzw. E2 geerdet. Die prinzipielle Arbeitsweise eines solchen SAW–Filters ist aus dem erwähnten Hewlett–Packard Journal bekannt und braucht daher hier nicht nochmals erläutert zu werden.

Die in Fig.2 dargestellte Struktur eines Richtwandlers, wie er als Wandler W1 oder W2 in einem SAW–Filter nach Fig.1 eingesetzt werden könnte, umfasst drei Elektrodengruppen GL, GM, GR, von denen die mittlere Gruppe GM je 5 Elektrodenfinger aufweist, die mit dem Anschluss P1 bzw. N1 verbunden sind. Demgegenüber weisen die Gruppen GL und GR nur je 3 an den Anschluss P1 bzw. N1 angeschlossene Elektrodenfinger auf. Zudem sind alle Halbgruppen durch eine mäanderförmige Erdleitung voneinander getrennt, mit der weitere jeweils zwischen zwei Gruppenelektrodenfingern angeordnete Elektrodenfinger verbunden sind. Dabei ist gemäss dem Stand der Technik der geometrische Abstand zwischen zwei Elektrodenfingern bei allen drei Gruppen GL, GM und GR immer gleich gross ist. Im Gegensatz zu bekannten Strukturen ist daher die Breite der Gruppe GM grösser als die Breite der Gruppe GR oder GL. Wenn somit nur schon die Halbgruppenmitten $q1$, $q2$ und $q3$ dreier aufeinanderfolgenden Halbgruppen in zwei ungleichen Abständen $\overline{q1q2}$ und $\overline{q2q3}$ liegen, ist die mäanderförmige Erdleitung aperiodisch.

Selbstverständlich kann der Wandler W1 mehr als drei Gruppen und/oder eine andere Anzahl Elektrodenfinger pro Gruppe aufweisen. Z.B.: 6 Gruppen GM mit je 3 Fingerelektroden und je 7 Gruppen GL bzw. GR mit je 2 Fingerelektroden nach der Formel 7GL2 / 6GM3 / 7GR2. Eine Gruppe kann auch aus je nur eine Fingerelektrode für jede Phasenlage bestehen. Die Wandlerstruktur kann auch unsymmetrisch sein. Der Empfangswandler W2 kann gleich aufgebaut sein, wie der Wandler W1 nach Fig.2. Vorzugsweise soll aber die Struktur des Empfangswandlers W2 kürzer als die des ihm zugeordneten Sendewandlers sein und zwar mit weniger Gruppen und/oder mit weniger Fingerelektroden pro Gruppe. Z.B.: Für W1 = 7GL2 / 6GM3 / 7GR2 kann W2 = 4GL2 / 0GM / 4GR2 sein. Es ist auch möglich, einen Wandler W1 oder W2 nach dem Stand der Technik zu wählen, das heisst, einen Wandler mit einer konstanten Anzahl Elektroden pro Gruppe, wobei die Elektrodenlängen gleich oder, wie in Fig.3 dargestellt, ungleich sein können.

BAD ORIGINAL

Ein SAW-Filter mit mindestens einer Elektrodenstruktur gemäss Fig.2 erweist sich als relativ günstig in bezug auf die Frequenzcharakteristik, wobei bei geeigneter Dimensionierung auch eine gute Anpassung an die Quellenimpedanz möglich ist.

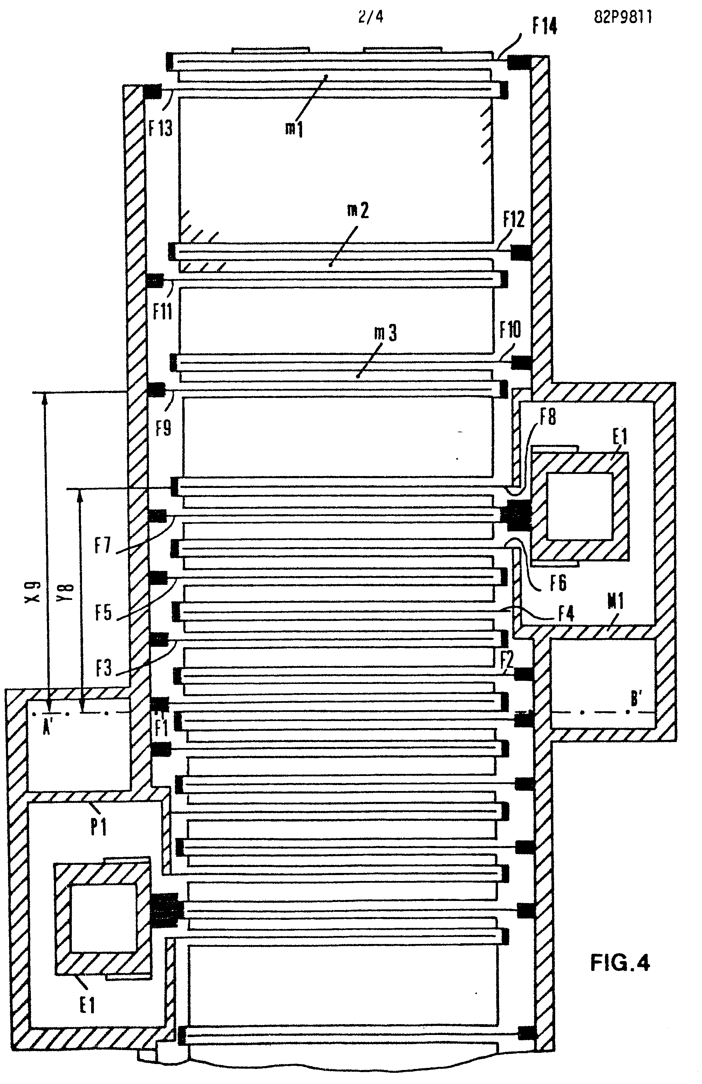

Zur Vereinfachung der Zeichnung ist in Fig.4 nur die Hälfte einer Struktur für einen Wandler W1 oder W2 vollständig dargestellt. Dies geschieht ohne Informationsverlust, weil die Struktur punktsymmetrisch ist. In dieser Struktur ist eine Referenzachse A'B' gezeichnet, auf der der in der Figur nicht angegebene Symmetriepunkt 0 liegt. Diese Strukturhälfte weist 7 mit dem Anschluss P1 und 7 mit dem Anschluss N1 verbundene Fingerelektroden F1, F3, ... bzw. F2, F4 ... auf, die parallel zur Achse A'B' angeordnet sind.

Der Abstand der Fingerelektroden F1, F3, ... und F2, F4, ... zur Achse A'B' sei Xi mit i=1, 3, ... bzw. Yi mit i=2, 4 ...

In Fig.4 sind die Abstände Xi bzw. Yi proportional zu den Werten Zi der folgenden

TABELLE I

| | | | | | |
|---|---|---|---|---|---|
| Z1 = 2 | D1 = 15 | Z2 = 9 | D2 = 15 | U1 = 7 | U2 = 8 |
| Z3 = 17 | D3 = 15 | Z4 = 24 | D4 = 15 | U3 = 7 | U4 = 8 |
| Z5 = 32 | D5 = 15 | Z6 = 39 | D6 = 15 | U5 = 7 | U6 = 8 |
| Z7 = 47 | D7 = 30 | Z8 = 54 | D8 = 30 | U7 = 7 | U8 = 23 |
| Z9 = 77 | D9 = 26 | Z10 = 84 | D10 = 26 | U9 = 7 | U10 = 19 |
| Z11 = 103 | D11 = 45 | Z12 = 110 | D12 = 45 | U11 = 7 | U12 = 38 |
| Z13 = 148 | | Z14 = 155 | | U13 = 7 | |

wobei $Zi = k \cdot Xi$ für $i = 1, 3, \ldots$ und $Zi = k \cdot Yi$ für $i = 2, 4, \ldots$ ist.

In Tabelle I sind die Werte D1, D3, ... die Differenzen zwischen jeweils zwei nacheinander folgenden Werten der Reihe Z1, Z3, ... und die Werte D2, D4, ... die Differenzen zwischen jeweils zwei nacheinander folgenden Werten der Reihe Z2, Z4, ... Die Werte U1, U3, ... entsprechen jeweils der Differenz zwischen zwei Werten Zi und Zj ein und derselben Reihe, wie beispielsweise U5 = Z6-Z5 = 7. Die Werte U2, U4, ... entsprechen jeweils der Differenz Ui = Z (i+1) – Zi, z.B. U4 = Z5 – Z4 = 8. Aus der Tabelle I ist ersichtlich, dass die Reihen D1, D3, ... und D2, D4, ... sehr wenig von der idealen Reihe 15, 15, 15, 30, 30, 45 abweichen, wobei B = 15 die Basis der Reihe ist.

Die Werte der Reihe U1, U3, ... sind ungefähr konstant und gleich 7. Der Wert U1 kann so gewählt werden, dass die Bedingung

$$2 . U1 < B$$

gilt. Mit U1 = 7 und B = 15 ist diese Bedingung erfüllt. Im Gegensatz dazu sind die Werte U2, U4, U6, U8, U10, U12 nicht konstant, was in Filtern nach dem Stand der Technik nicht der Fall ist. Wenn m1, m2, m3 die Gruppenmitten der drei letzten Elektrodengruppen (F13, F14), (F11, F12) und (F9, F10) sind, so ist der Abstand zwischen den Punkten m1 und m2 = 7 + U12 = 45 und der Abstand $\overline{m2\ m3}$ = 7 + U10 = 19 + 7 = 26; daraus ergibt sich, dass $\overline{m1\ m2} > \overline{m2\ m3}$ ist. Im Allgemeinen können die Reihen D1, D3, ... und D2, D4, ... folgende ideale Form annehmen

B, B, B, .... B, 2B, 2B, ... 2B, 3B, 3B ....

Es ist jedoch günstig, bei mindestens einem Wert eine Abweichung in der Grössenordnung von $\pm$ 1 bis $\pm$ 34 % vorzusehen, um eine gewisse Unsymmetrie einzubauen. So wurden die Werte D9 = D16 = 26 statt 30 nach Ermessen gewählt.

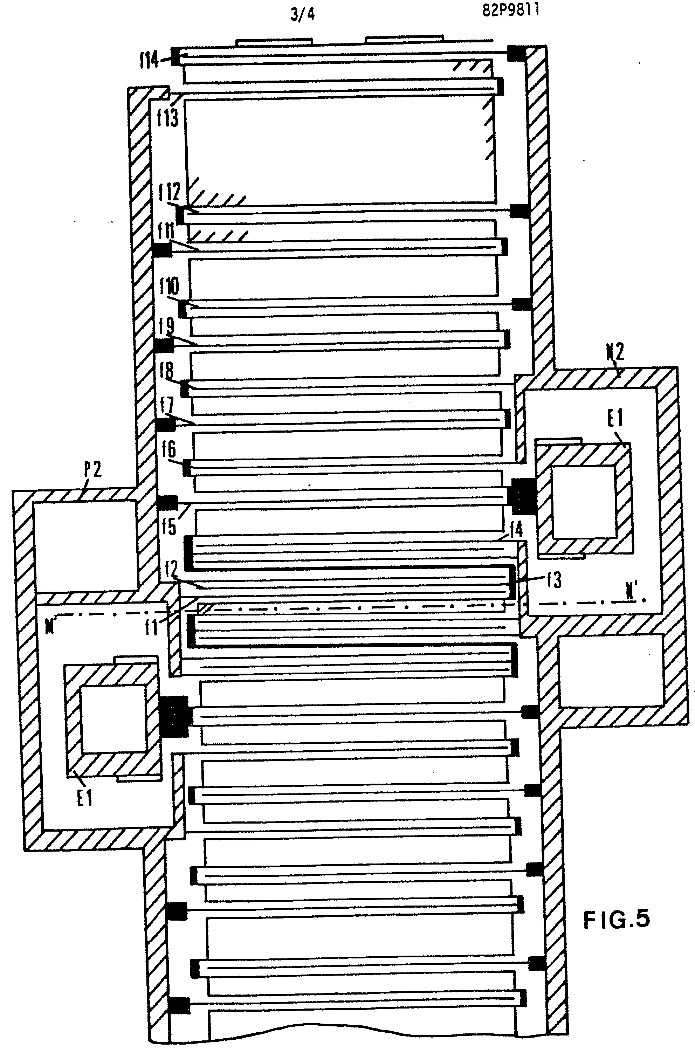

Zur Vereinfachung ist auch in Fig.5 nur die Hälfte einer punktsymmetrischen Struktur mit einer Referenzachse M'N' für einen Wandler W1 oder W2 vollständig dargestellt. Diese Strukturhälfte weist je 7 mit dem Anschluss P2 bzw. N2 verbundene Fingerelektroden f1, f2, f5, f7, f9, f11, f13 bzw. f3, f4, f6, f8, f10, f12, f14 auf, die parallel zur Achse M'N' angeordnet sind. Der Abstand der Fingerelektroden f1, f2, f5, ... bzw. f3, f4, f6, ... zur Achse M'N' sei xi mit i = 1, 2, 5, ... bzw. yi mit i = 3, 4, 6, ... In Fig.5 sind die Abstände xi bzw. yi proportional zu den Werten zi der folgenden

T A B E L L E  II

| | | | | | |
|---|---|---|---|---|---|
| z1 = 2,5 | d1 = 4 | z3 = 11,5 | d3 = 4 | u1 = 9 | u3 = 5 |
| z2 = 6,5 | d2 = 19 | z4 = 15,5 | d4 = 19 | u2 = 9 | u4 = 10 |
| z5 = 25,5 | d5 = 19 | z6 = 34,5 | d6 = 19 | u5 = 9 | u6 = 10 |
| z7 = 44,5 | d7 = 19 | z8 = 53,5 | d8 = 19 | u7 = 9 | u8 = 10 |
| z9 = 63,5 | d9 = 22 | z10 = 72,5 | d10 = 22 | u9 = 9 | u10 = 13 |
| z11 = 85,5 | d11 = 38 | z12 = 94,5 | d12 = 38 | u11 = 9 | u12 = 29 |
| z13 = 123,5 | | z14 = 132,5 | | u13 = 9 | |

wobei zi = k·xi für i = 1, 2, 5, 7, 9, ... und zi = k·yi für i = 3, 4, 6, 8, ... ist.

0104314

Die Werte di ergeben sich aus der Differenz zwischen jeweils zwei aufeinanderfolgenden Werten der Reihe z1, z2, z5, z7, ... bzw. z3, z4, z6, ... Die Werte u1, u2, u5, u7, ... entsprechen jeweils der Differenz zwischen zwei Werten zi und zj ein und derselben Reihe, wie beispielsweise u7 = z8 - z7 = 9 und die Werte u3, u4, u6, u8, u10, u12 den Differenzen zwischen zwei Werten zi und zj aus zwei nacheinander folgenden Reihen, wie u6 = z7 - z6 = 10.

Die Tabelle II zeigt, dass die Reihen d2, d5, d7, d9, d11 und d3, d4, d6, d8, d10, d12 relativ wenig von der idealen Reihe

$$19; 19; 19; 19; 38$$

abweichen, wobei b = 19 die Basis der Reihe ist. Lediglich bei der vorletzten Stelle wurde für d9 und d10 anstatt 19 den Wert 22 gewählt, um eine gewisse Unsymmetrie einzubauen. Die Werte der Reihe u1, u2, u5, u7, ... sind ungefähr konstant und gleich 9. Der Wert u1 kann so gewählt werden, dass die Bedingung

$$2 \cdot u1 < b$$

gilt. Mit u1 = 9 und b = 19 ist diese Bedingung erfüllt. Der Wert z1 ergibt sich nach Ermessen bei der Einfügung einer ersten Fingerelektrode in den noch zur Verfügung stehenden Raum. Demgegenüber zeichnen sich die Werte u3, u5, u6, u8, u10, u12 dadurch aus, dass sie nicht konstant sind.

Dabei ist zu beachten, dass solche Strukturen nicht unbedingt symmetrisch sein müssen. Zudem kann jeweils die Konzentration der Elektroden auch an den Rändern vorgesehen sein. In den Fig.4 und 5 ist die Erdleitung ununterbrochen dargestellt; sie kann aber auch stückweise unterbrochen und parallelgeschaltet sein.

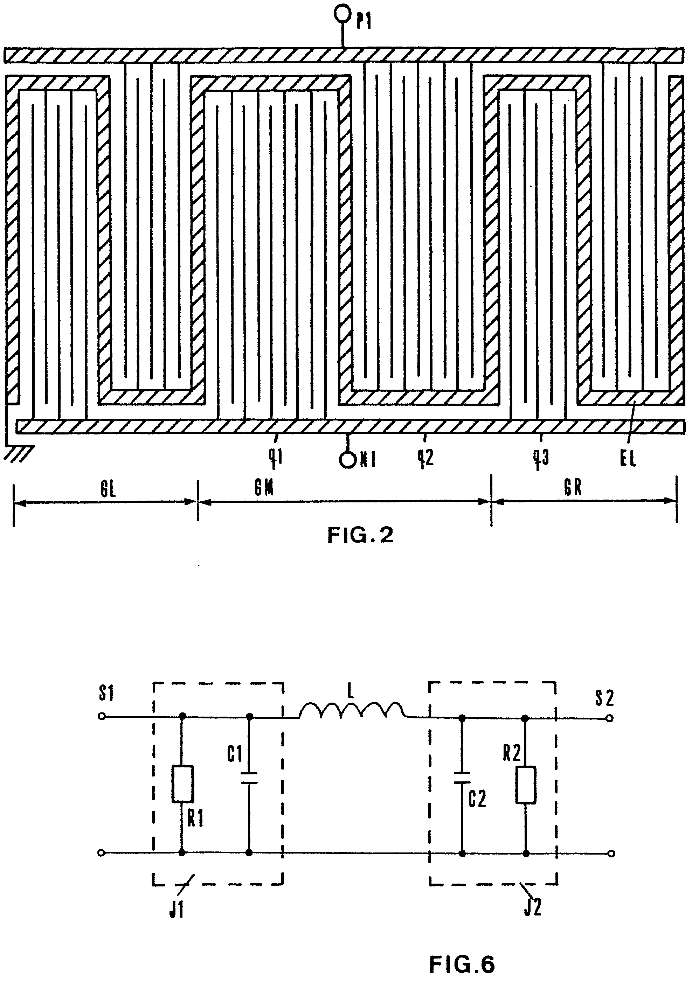

Der in Fig.6 dargestellte Phasenschieber besteht aus einer Pi-Schaltung mit einer Längsinduktivität L und zwei Querimpedanzen J1 und J2, die je durch ein RC-Glied R1, C1 bzw. R2, C2 gebildet sind. Ein weiterer Vorteil der Strukturen nach Fig.2, 4 und 5 gegenüber einer Struktur nach Fig.3 besteht darin, dass die RC-Glieder J1 und J2 gänzlich oder mindestens zum Teil durch die Eigenkapazität und den Eigenwiderstand der Struktur gebildet sein können. Somit kann als Phasenschieber-Schaltung lediglich eine externe Induktivität L dienen. Entsprechende Vorteile werden beibehalten, wenn an der Stelle einer einfachen Pi-Schaltung Phasenschieber höherer Ordnung eingesetzt werden.

Schliesslich sei noch bemerkt, dass die Abmessungen der Fingerelektroden in Fig.2 bis 5 nicht massstabgerecht dargestellt sind. Insbesondere sollten sie häufig eine grössere Ausdehnung in der Länge aufweisen. Zur Vereinfachung der Darstellung sind die Erdleitungen in den Figuren nur teilweise durch Schraffur angedeutet. In der Praxis soll gewöhnlich eine möglichst grosse Fläche für die Erdleitungen gewählt werden, weshalb die Fläche des Substrats zwischen den Elektrodenfingern weitgehend durch die mäanderförmige Erdleitung ausgefüllt ist.

In Fig.2, 4, und 5 sind die SAW-Filter und insbesondere die Elektroden nur schematisch dargestellt. Zur Anregung der akustischen Wellen in solchen SAW-Filtern müssen jedoch die Elektroden eine bestimmte Breite aufweisen, die zweckmässigerweise zumindest angenähert gleich L/4 gewählt wird, wobei die Breite der Zwischenräume auch annähernd L/4 sein kann, worin L die Wellenlänge der akustischen Oberflächenwelle ist. Im übrigen sind die Werte Zi und zi in den Tabellen I und II auch proportional zu L/4.

Zur Erzeugung einer Richtwirkung in den Wandlern eines SAW-Filters nach Fig.2 wird häufig die Breite der langen Abschnitte der mäanderförmigen Erdleitung abwechslungsweise gleich L/2 bzw. L dimensioniert.

Um Störeffekte 2. Ordnung abzuschwächen, können indessen kleine Abweichungen der angegebenen Elektrodenbreiten und Positionen in der Grössenordnung von einigen Prozenten sehr wirksam sein.

# PATENTANSPRUECHE

1. SAW-Filter mit einem piezoelektrischem Substrat, auf dem ein Sendewandler (W1) und/oder ein Empfangswandler (W2) mit fingerförmig ineinander greifenden Elektroden angeordnet sind, die halbgruppenweise entweder mit einem Anschluss (P1 oder P2) für ein Signal mit einer ersten Phasenlage oder mit einem Anschluss (N1 oder N2) für ein Signal mit einer zweiten Phasenlage verbunden sind, wobei eine mäanderförmige Erdleitung (EL) zwischen den Halbgruppen hindurchgeführt ist, d a d u r c h g e - k e n n z e i c h n e t , dass die Erdleitung mindestens eines der beiden Wandler in der Form einer aperiodischen Mäanderstruktur ausgebildet ist.

2. SAW-Filter nach Anspruch 1, d a d u r c h g e k e n n z e i c h n e t , dass die Elektrodenstruktur mindestens eines der beiden Wandler (W1 bzw. W2) wenigstens drei aufeinanderfolgende Halbgruppenmitten (q1, q2, q3) aufweist, die derart angeordnet sind, dass der Abstand der mittleren Halbgruppenmitte (q2) zu einer der zwei anderen (q1) grösser ist als die Summe vom Abstand dieser mittleren Halbgruppenmitte (q2) zu der anderen Halbgruppenmitte (q3) und der halben Wellenlänge (L) der akustischen Oberflächenwelle.

3. SAW-Filter nach Anspruch 1, d a d u r c h g e k e n n z e i c h n e t , dass die Elektrodenstruktur mindestens eines der beiden Wandler (W1 bzw. W2) wenigstens drei aufeinanderfolgende Gruppenmitten (m1, m2, m3) aufweist, die derart angeordnet sind, dass der Abstand der mittleren Gruppenmitte (m2) zu einer der zwei anderen (m1) grösser ist als der Abstand dieser mittleren Gruppenmitte (m2) zu der anderen Gruppenmitte (m3).

4. SAW-Filter nach Anspruch 1 oder 3, d a d u r c h g e k e n n z e i c h n e t , dass mehrere Fingerelektroden derselben Phasenlage untereinander in Abständen mit den Werten B1, B2, B3, ... angeordnet sind, für die die Bedingung

$$B1 \leq B2 \leq B3 \leq B4 \leq ...$$

gilt, wobei mindestens einmal das Gleichheitszeichen entfällt.

5. SAW-Filter nach Anspruch 4, d a d u r c h g e k e n n z e i c h n e t , dass die Abstandswerte B1, B2, B3, ... zumindest angenähert eine Reihe der Form

$$B, B, ... 2 \cdot B, ... 3 \cdot B, ...$$

bilden.

6. SAW-Filter nach Anspruch 5, d a d u r c h   g e k e n n z e i c h n e t, dass bei mindestens einem der Abstandswerte B, 2·B, 3·B, ... eine Abweichung des Abstandswertes bis $\pm$ 25% vorgesehen ist.

7. SAW-Filter nach einem der Ansprüche 1 bis 6, d a d u r c h   g e k e n n - z e i c h n e t, dass mehrere Fingerelektroden vorhanden sind, bei denen der Abstand zwischen einer Fingerelektrode der einen Phasenlage und der nächstliegenden Fingerelektrode der anderen Phasenlage jeweils zumindest annähernd gleich ist.

8. SAW-Filter nach einem der Ansprüche 1 bis 7, d a d u r c h   g e k e n n - z e i c h n e t, dass bei Einsatz von mindestens einem Phasenschieber die Eigenkapazität (C1, C2) und der Eigenwiderstand (R1, R2) der Wandlerstruktur zur Bildung der Eingangs- und/oder Ausgangs-RC-Glieder des Phasenschiebers verwendet sind.

0104314

1/4

82P9811

FIG.1

FIG.3

FIG.4

0104314

82P9811

FIG.5

FIG.2

FIG.6